Europäisches Patentamt

(19) **European Patent Office**

**Office européen des brevets**

(11) Numéro de publication: **0 042 776**

**A1**

(12) **DEMANDE DE BREVET EUROPEEN**

(21) Numéro de dépôt: **81400905.6**

(22) Date de dépôt: **05.06.81**

(51) Int. Cl.³: **G 11 B 5/09**
**G 06 F 11/10**
**//H04L1/10**

(30) Priorité: **19.06.80 FR 8013597**

(43) Date de publication de la demande:
**30.12.81 Bulletin 81/52**

(84) Etats contractants désignés:
**DE GB NL**

(71) Demandeur: **THOMSON-CSF**
**173, Boulevard Haussmann**
**F-75360 Paris Cedex 08(FR)**

(72) Inventeur: **de Couasnon, Tristan**
**THOMSON-CSF SCPI 173, bld Haussmann**
**F-75360 Paris Cedex 08(FR)**

(74) Mandataire: **Turlèque, Clotilde et al,**
**"THOMSON-CSF" - SCPI 173, bld Haussmann**
**F-75360 Paris Cedex 08(FR)**

(54) **Dispositif de correction, en temps réel, d'erreurs, sur des données enregistrées sur un support magnétique.**

(57) Ce dispositif de correction, destiné à traiter des données en parallèle sur plusieurs voies, met en oeuvre deux niveaux de correction à partir d'éléments binaires de redondance ajoutés aux données transmises: des éléments binaires résultant d'un codage par blocs de données série sur chacune des voies par un code de Fire raccourci (200,180), et des e.b. de parité relatifs chacun à la moitié des voies parallèles. Un ensemble de décodeurs (5) fournit les données corrigées à partir des e.b. résultant du code de Fire qui se substituent lorsqu'il y a lieu aux données stockées dans une mémoire (7). Lorsque les erreurs dans un bloc de l'une des voies sont trop longues pour être ainsi corrigées, deux calculateurs de parité (16 et 17) permettent, associés à des multiplexeurs (14 et 18, et 15 et 19), de corriger les e.b. erronnées.

Application, notamment, à la correction en temps réel de données restituées par des enregistreurs-lecteurs magnétiques multipistes rapides.

./...

FIG_3

1

# DISPOSITIF DE CORRECTION, EN TEMPS REEL, D'ERREURS
## SUR DES DONNEES ENREGISTREES SUR UN SUPPORT MAGNETIQUE

L'invention se rapporte à un dispositif de correction, en temps réel, d'erreurs sur des données enregistrées sur un support magnétique.

Les enregistreurs-lecteurs de données numériques à haut débit peuvent être utilisés, en particulier, pour enregistrer sur des supports magnétiques des images transmises en numérique et les restituer aux fins de traitement d'images par ordinateur. Pour de tels traitements, il est absolument nécessaire que l'image restituée par l'enregistreur-lecteur soit totalement exempte d'erreurs. En effet, les techniques dites "de dissimulation" consistant, dans un premier temps, à détecter les erreurs, et dans un deuxième temps, à les masquer en recopiant, à la place des éléments erronés, des éléments adjacents sont utilisables pour la visualisation d'images, l'œil étant tolérant, mais ne le sont pas pour une restitution en vue d'un traitement informatique.

Des dispositifs de correction d'erreurs sont connus pour corriger des erreurs détectées dans des suites de données restituées par des enregistreurs magnétiques multipistes lents. Ces dispositifs de correction fonctionnent par double contrôle de parité : un contrôle transversal, une piste de parité longitudinale étant prévue à cet effet, et un contrôle de parité longitudinal, une piste de parité transversale étant prévue à cet effet. Un double contrôle croisé permet la correction d'erreurs simples car isolées.

Il existe également des dispositifs dans lesquels, lors de l'enregistrement, des éléments binaires codés suivant le contenu des données selon un code correcteur d'erreur sont inscrits en plus des données, piste par piste. De tels dispositifs permettent de corriger des erreurs isolées ou en petits paquets. Le nombre d'erreurs susceptibles d'être corrigées est bien sûr fonction de la redondance introduite par les éléments binaires supplémentaires. La majorité des applications utilisent des codes de blocs raccourcis susceptibles de corriger de 4 à 10 erreurs avec une redondance comprise entre 9,5 et 15%. A partir de cela, pour arriver à une capacité de correction suffisante, des techniques d'entrelaçage nécessitant des mémoires de changement de format sont mises en œuvre.

Pour un enregistreur magnétique rapide utilisé dans un système de traitement de données en temps réel, ces différentes techniques de correction ne sont pas suffisantes.

L'invention a pour objet un dispositif de correction, en temps réel, d'erreurs sur des données enregistrées par un enregistreur rapide sur un support magnétique multipiste en parallèle, la redondance dans les données enregistrées étant assez faible, mais le dispositif ayant une capacité de correction grande. Dans le cadre des applications en traitement de données, lorsque la capacité de correction est dépassée, le système indique que le support magnétique présente un défaut et il est alors rejeté.

Selon l'invention, un dispositif de correction, en temps réel, d'erreurs sur des données enregistrées sur un support magnétique multipiste, comportant un dispositif de traitement des données numériques avant leur enregistrement en parallèle sur un enregistreur-lecteur multipistes et un dispositif de traitement des données numériques restituées après leur lecture en parallèle sur l'enregistreur-lecteur, est principalement caractérisé en ce que ce dispositif de correction met en œuvre deux modes de correction associés ne consommant qu'une redondance totale faible, un mode de correction d'erreurs courtes à partir d'éléments binaires de redondance introduits par le dispositif de traitement de données avant leur enregistrement par un codage détecteur correcteur d'erreurs du type code de Fire raccourci introduisant pour un bloc de N éléments binaires en série à enregistrer sur une piste de l'enregistreur vingt éléments binaires de redondance, et un mode de correction d'erreurs longues mettant en œuvre des éléments binaires de parité, à enregistrer sur au moins une piste à réserver à cet effet, résultant du codage des éléments binaires parallèles à enregistrer simultanément.

L'invention sera mieux comprise et d'autres caractéristiques apparaîtront à l'aide de la description qui suit en référence aux figures annexées.

- la figure 1 est un schéma d'un circuit de traitement des données reçues avant enregistrement sur le support magnétique, qui est une partie du dispositif de correction selon l'invention ;

- la figure 2 est un schéma détaillé d'un circuit codeur utilisé dans le circuit de traitement des données avant enregistrement ;

- la figure 3 est un schéma général du circuit de détection et de correction des erreurs sur les données restituées par l'enregistreur qui est l'autre partie du dispositif de correction selon l'invention ;

- la figure 4 est un schéma détaillé d'un circuit décodeur utilisé dans le circuit de détection des erreurs sur les données restituées.

L'invention s'applique particulièrement aux systèmes de traitement de données numériques utilisant des enregistreurs magnétiques multipistes, les données étant enregistrées en parallèle sur plusieurs pistes. Sur ces pistes, deux types d'erreurs sont susceptibles de se produire :

- des erreurs courtes, soit 1 à 7 erreurs groupées ;
- des erreurs longues de 8 à 512 erreurs groupées.

Le dispositif de correction permet de corriger ces deux types d'erreurs en temps réel.

Pour cela deux niveaux de correction sont mis en œuvre, ces deux niveaux se traduisant chacun par l'enregistrement d'éléments binaires supplémentaires.

Pour un premier niveau de correction, un code détecteur correcteur d'erreur particulier est utilisé : les données entrant sur chacune des pistes sont découpées en blocs de 180 éléments binaires. A chacun de ces blocs sont associés des éléments binaires supplémentaires, dits de redondance, résultant d'un codage de ces blocs suivant un code détecteur correcteur d'erreur du type code de Fire raccourci. Ce code permet la correction de sept erreurs consécutives au maximum lors de la restitution du bloc correspondant de 180 éléments binaires, à partir de 20 éléments binaires de redondance et la détection des erreurs non corrigées avec un taux d'erreur dans cette détection au plus égal à $10^{-7}$.

Pour un deuxième niveau de correction, deux pistes sont réservées à l'enregistrement d'éléments binaires de parité calculés à partir des éléments binaires de même rang enregistrés en parallèle sur les autres pistes disponibles, pour l'enregistrement des données ; le calcul de parité est effectué en associant les pistes en deux groupes, par exemple les pistes paires et les pistes impaires, ce qui donnera une piste de parité correspondant aux pistes paires et une piste de parité correspondant aux pistes impaires.

Ce dispositif de correction et son fonctionnement sont décrits ci-après en référence aux figures.

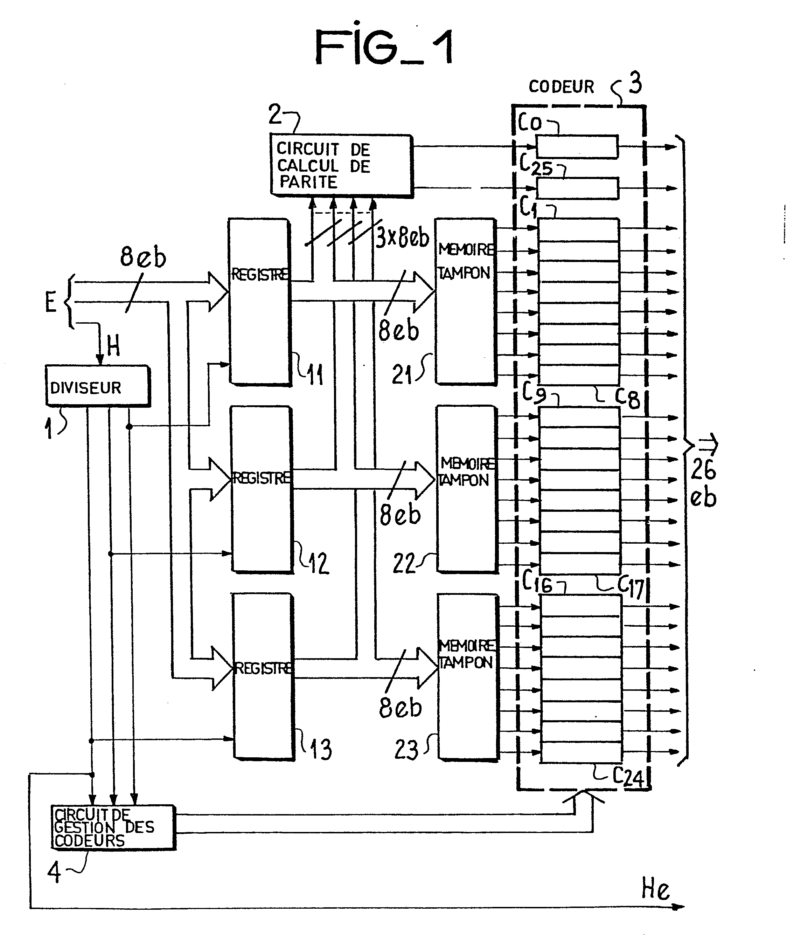

La figure 1 représente la partie "enregistrement" du dispositif de correction suivant l'invention, c'est-à-dire le dispositif de traitement des données numériques reçues avant leur enregistrement sur le support magnétique multipiste. Pour un enregistrement de données à grand débit l'enregistreur multipiste enregistre les données en parallèle sur toutes ses pistes. En général les données numériques arrivent par octets à un rythme F.

L'entrée E du dispositif comporte une ligne d'entrée permettant de transmettre les huit éléments binaires (dits "e.b" dans la suite de la description) en parallèle et une entrée d'horloge H. Avec un enregistreur multipiste utilisant des bandes magnétiques comportant 26 pistes, il est possible d'enregistrer des e.b en parallèle sur ces 26 pistes. Ces pistes peuvent être utilisées de la manière suivante : - enregistrement simultané de trois octets arrivant successivement sur l'entrée E - les deux pistes supplémentaires peuvent alors être utilisées pour la correction des erreurs détectées lors de la restitution. Dans un mode de réalisation de l'invention, ces deux pistes sont utilisées pour enregistrer des éléments binaires de contrôle de parité, une piste correspondant au groupe des pistes paires et l'autre correspondant au groupe des pistes impaires. La partie correspondante du dispositif comporte les éléments suivants : un diviseur 1 connecté à l'entrée d'horloge H, divisant par trois le rythme F de l'horloge H et fournissant sur ses trois sorties des signaux de rythme $f = \frac{F}{3}$ décalés l'un par rapport au suivant d'une période du signal de rythme F. La ligne d'entrée est connectée à trois registres de 8 e.b, 11, 12 et 13 dont le chargement est commandé respectivement par les trois signaux de sortie du diviseur appliqué à leurs entrées d'horloge. Les sorties parallèles de ces trois registres 11, 12 et 13 sont reliées d'une part aux entrées multiples de trois mémoires tampon 21, 22 et 23 correspondantes, et d'autre part à un double circuit de calcul de parité 2.

Les entrées de ce circuit 2 étant numérotées 1 à 24, les données correspondantes sont destinées à être inscrites en parallèle sur les pistes correspondantes 1 à 24 de l'enregistreur. Le double circuit de contrôle calcule, toutes les trois périodes de l'horloge d'entrée, c'est-à-dire au rythme f, deux e.b de parité, l'un correspondant aux e.b présents sur les entrées impaires 1, 3, 5 ... 23 et l'autre correspondant aux e.b présents sur les entrées paires 2, 4 ... 24.

Le premier est destiné à être enregistré en même temps que les données sur l'une des deux pistes restantes, par exemple au bord de la bande, soit la piste n° 25 par exemple, et l'autre sur la piste située sur l'autre bord, numérotée 0 par exemple. Les mémoires tampon 21, 22, 23 sont telles que, lorsque les e.b de contrôle de parité sont disponibles sur les sorties du double circuit de calcul 2, les données présentes sur les sorties de ces registres sont celles qui ont servi au calcul. Le rythme de sortie des e.b du circuit de calcul de parité et des mémoires tampon 21, 22 et 23 est f'.

Un ensemble de 26 codeurs $C_o ... C_{25}$ , 3 , permet de coder les données délivrées en série sur chacune des sorties du circuit 2 et des registres 21, 22, 23. Ce codage destiné à déterminer les e.b de redondance à ajouter à un bloc d'e.b série est réalisé de la manière suivante : le code choisi est un code dérivé du code de Fire raccourci en (200, 180). Cette écriture signifie que les e.b série sont groupés en blocs de 180 e.b à partir desquels sont déterminés 20 e.b de redondance écrits à la suite du bloc de 180 e.b, ce qui conduit à l'inscription de 200 e.b pour 180 e.b de données.

En effet, afin de réaliser un dispositif dont l'organisation matérielle soit aussi aisée que possible, en particulier en vue du décodage et de la restitution, il est souhaitable que le nombre d'e.b dans les blocs soit un nombre "simple", comme le nombre d'e.b de redondance. Il est de plus souhaitable que la capacité de correction soit aussi grande que possible avec une redondance aussi faible que possible pour des blocs de longueur donnée.

Or un code issu du code de Fire (1662, 1643) raccourci en (200, 180) permet de corriger des erreurs courtes (1 à 7 erreurs en paquet) la redondance introduite, égale à 10%, étant faible. La redondance totale tenant compte de la périodicité des blocs et des e.b de parité est alors :
$$\frac{\text{e.b donnés}}{\text{e.b enregistrés}} = \frac{180 \times 24}{200 \times 26} = 0,83 \text{ , soit 17\% de redondance.}$$

Le taux d'erreur indétectable par le code de Fire raccourci (200, 180) est de $9 \times 10^{-7}$.

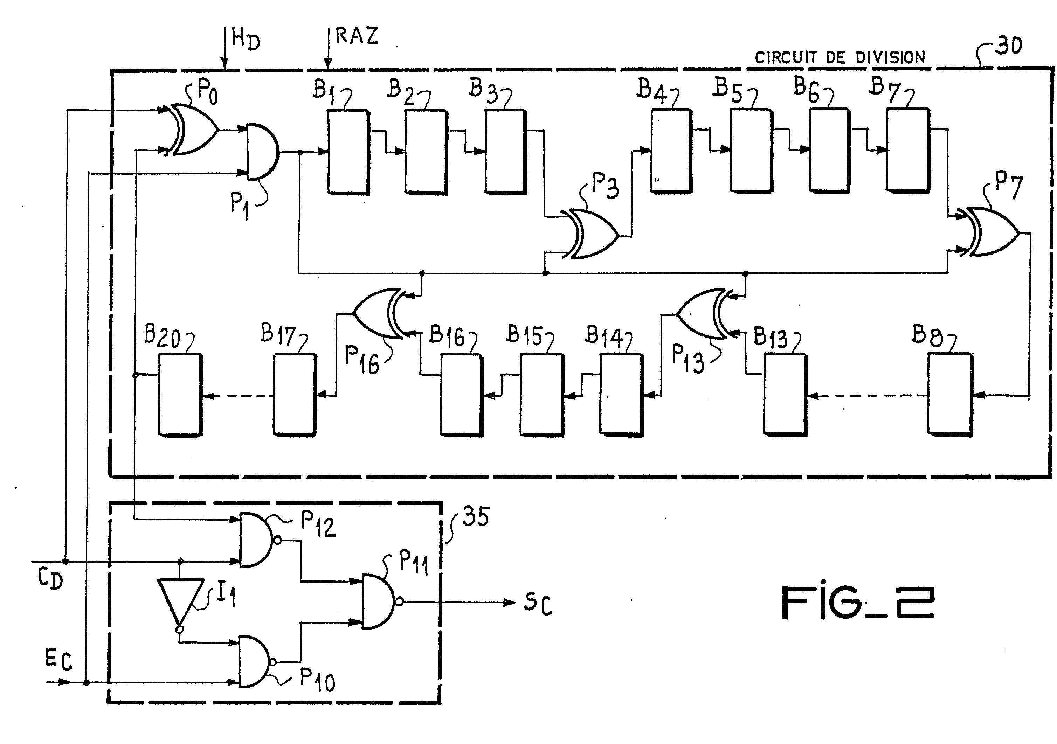

Les codeurs $C_o$ à $C_{25}$ découpent donc les données transmises sur leurs entrées en blocs de 180 e.b ; à chaque bloc ils ajoutent les 20 e.b correspondants. Pour cela, un circuit de gestion des codeurs, 4, reçoit les signaux d'horloge issus du diviseur 1 et élabore les signaux de commande destinés aux codeurs. La structure et le fonctionnement des codeurs sont décrits en détails ci-après en référence à la figure 2.

Les sorties des 26 codeurs et la sortie d'horloge d'écriture $H_e$ , qui transmet un signal d'horloge correspondant au rythme des données binaires issues des codeurs, sont à relier aux entrées correspondantes de l'enregistreur magnétique multipiste utilisé pour l'enregistrement, puis la lecture des données.

Sur la figure 2 représentant plus précisément l'un des codeurs, les données à coder se présentent en série sur l'entrée $E_C$ du codeur. Elles sont transmises d'une part à la sortie $S_C$ de données de ce codeur par un circuit 35, et à un circuit 30 de division par le polynôme générateur du code de Fire, d'autre part. Ce polynôme est :

$$g(x) = (x^{13} + 1)(x^7 + x^3 + 1)$$
$$= x^{20} + x^{16} + x^{13} + x^7 + x^3 + 1 .$$

Ce code est normalement utilisé pour le codage de blocs de données longs, 1643 e.b en série donnant 20 e.b de redondance. Dans le dispositif suivant l'invention le codage est réalisé comme indiqué ci-dessus sur des blocs courts de 180 e.b. Le circuit de division 30, dans chaque codeur $C_i$, effectue la division du polynôme formé par la suite des e.b d'entrée par le polynôme $g(x)$ et donne donc les 20 e.b de redondance qui sont transmis à la suite des 180 e.b d'information. Pour cela l'horloge d'appel des données dans les registres tampon est une horloge de période T' plus courte que la période T de l'horloge d'entrée et telle que $180T = 200T'$, 180 tops de l'horloge de période T' permettent de faire sortir les e.b d'un bloc puis pendant 20 périodes du signal de période T', aucune information n'est sortie de la mémoire d'image formée par les mémoires tampon (21, 22, 23). Un signal de commande de 20 tops d'horloge permet alors de transmettre, à la suite de ces 180 e.b, les 20 e.b formant le résultat de la division. Le circuit de division comporte 20 bascules en cascade, $B_1$ à $B_{20}$, (les bascules $B_9$ à $B_{12}$ et $B_{18}$ et $B_{19}$ n'ont pas été représentées pour alléger le dessin), la sortie de l'une étant reliée soit directement, soit par l'intermédiaire d'une porte OU exclusif respectivement $P_3$, $P_7$, $P_{13}$, $P_{16}$ pour les bascules de rangs 3, 7, 13, 16, à l'entrée de la suivante. La sortie de la dernière, de rang 20, est reliée à l'entrée du circuit par l'intermédiaire d'une porte OU exclusif d'entrée, $P_o$. Les secondes entrées des portes $P_3$, $P_7$, $P_{13}$, $P_{16}$ sont reliées à l'entrée de $B_1$. Une porte ET, $P_1$, insérée entre la sortie de la porte $P_o$ et l'entrée de la bascule $B_1$ reçoit sur sa seconde entrée un signal de commande de division $C_D$, fourni par le circuit de gestion des codeurs (4 sur la figure 1).

Le circuit de codage $C_i$ comporte également une entrée d'horloge de décalage $H_D$ reliée aux entrées de décalage des bascules et une entrée de remise à zéro RAZ reliée aux entrées de RAZ de ces bascules. L'entrée du circuit de division reçoit la suite des 180 e.b sortis de la mémoire d'image.

Cette suite est également appliquée, comme indiqué ci-dessus, à une première entrée d'un circuit 35 qui les transmet directement à la sortie du codeur $C_i$ par l'intermédiaire de deux portes NON ET, $P_{10}$ et $P_{11}$, la première recevant sur sa seconde entrée le signal de commande de division inversé par un inverseur $I_1$. La suite des 20 e.b, formant le résultat de la division, fournie par le circuit 30 est appliquée à l'entrée d'une troisième porte NON ET $P_{12}$ du circuit 35, dont la seconde entrée reçoit directement le signal de commande de division. La sortie de cette porte $P_{12}$ est reliée à la seconde entrée de la porte $P_{11}$ dont la sortie est la sortie du circuit codeur $C_i$, $S_C$.

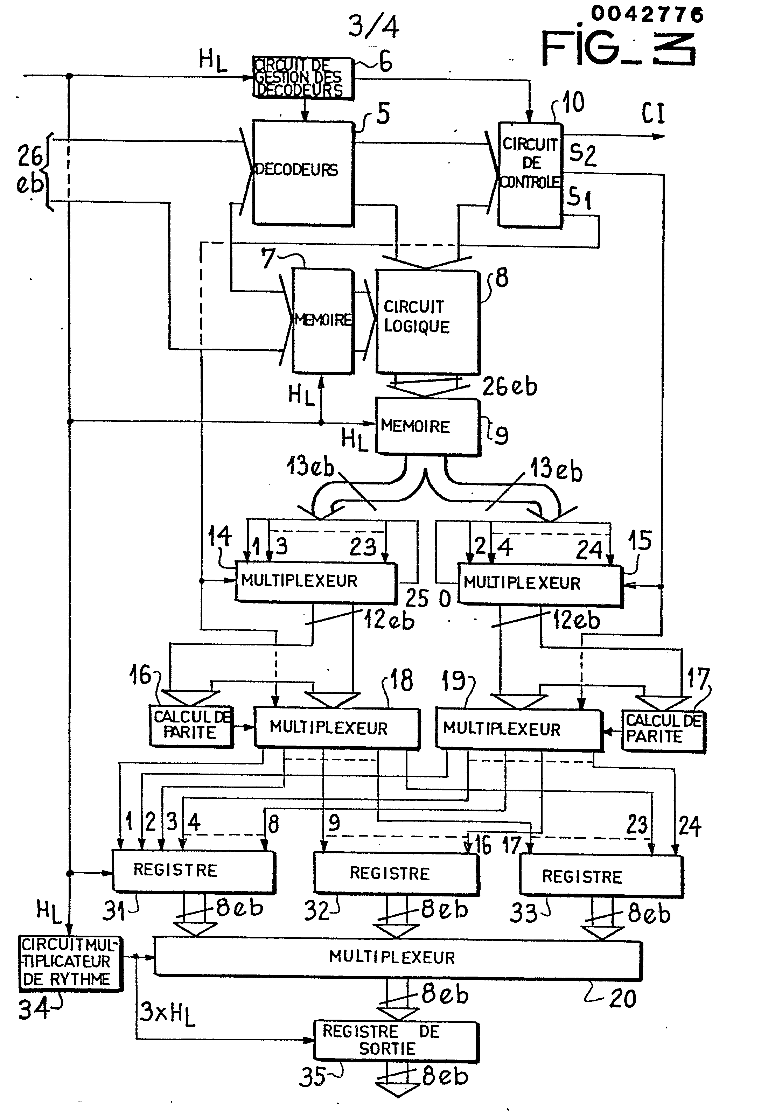

Le circuit associé de détection et de correction des erreurs sur les données restituées par l'enregistreur est représenté sur la figure 3. La lecture des données, comme leur enregistrement, peut être faite en parallèle sur toutes les pistes de l'enregistreur. Pour un enregistreur tel que celui décrit ci-dessus comportant 26 pistes, 26 sorties de lecture de données correspondant à ces 26 pistes sont prévues. Une sortie d'horloge de lecture est également prévue sur l'enregistreur. Cette sortie d'horloge délivre un signal d'horloge $H_L$ synchrone des données binaires délivrées en parallèle sur les 26 pistes. Les 26 sorties de l'enregistreur sont à relier aux entrées de 26 décodeurs $D_o$ à $D_{25}$ formant un ensemble 5 permettant de détecter les erreurs à partir du code détecteur correcteur d'erreurs ayant donné les 20 e.b de redondance ajoutés à chacun des blocs de 180 e.b de données.

Le fonctionnement de ces codeurs $D_o$ à $D_{25}$ est commandé par un circuit de gestion des décodeurs, 6, dont l'entrée est à relier à la sortie d'horloge de lecture de l'enregistreur.

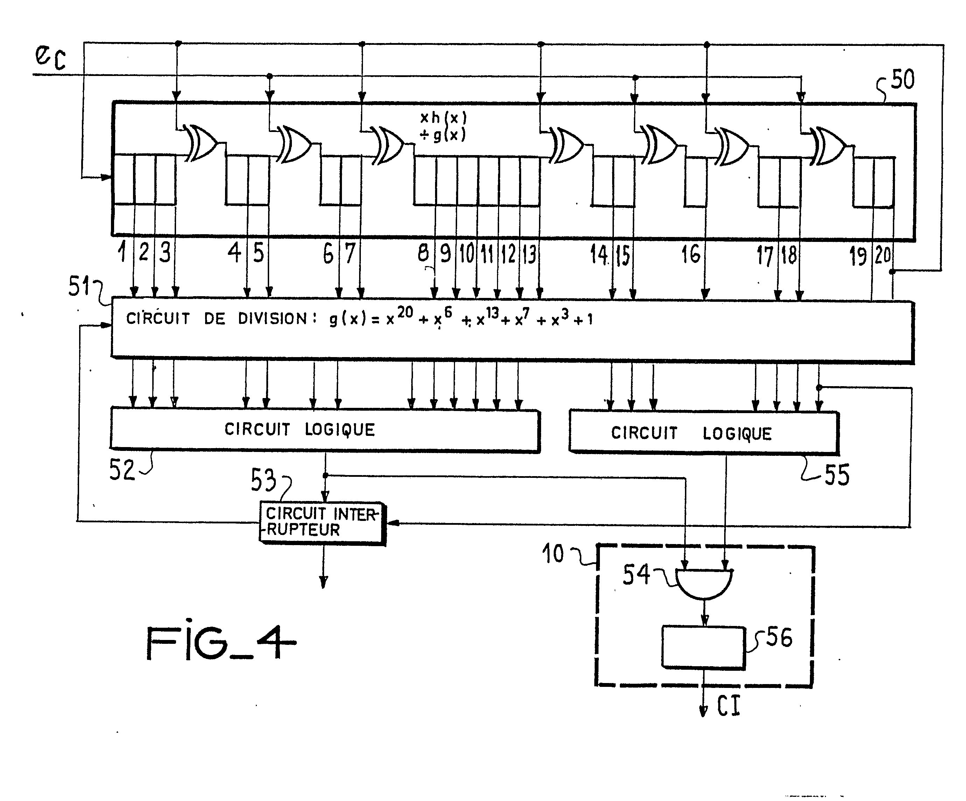

La structure et le fonctionnement des décodeurs correcteurs d'erreurs sont précisés ci-après en référence à la figure 4.

Les décodeurs fournissent la suite des e.b de correction au même rythme que les données lues. En même temps que les données lues sont traitées par les décodeurs correcteurs d'erreurs, ces données sont également transmises à une mémoire 7, de capacité 192 x 26 organisée en 26 lignes de 192 e.b. Dans cette mémoire sont mis en mémoire seulement les 180 e.b de données utiles formant les blocs. La détection des erreurs et leur correction est telle que, à la fin de la lecture d'un bloc et des e.b de redondance correspondants, les détecteurs correcteurs $D_o$ à $D_{25}$ délivrent une suite de 180 e.b dans laquelle les "1" indiquent la présence d'une erreur.

Un circuit logique, 8, formé de portes OU exclusif reçoit les données lues sur les 26 lignes de la mémoire 7 et simultanément les 26 e.b de sortie des détecteurs d'erreurs, 5, $D_o$ à $D_{25}$. Ainsi, lorsqu'un 1 indique la présence d'une erreur, l'e.b 0 ou 1 présent dans la mémoire est corrigé, la sortie de la porte OU étant alors 1 ou 0 respectivement. Lorsqu'un 0 indique qu'il n'y a pas d'erreurs, la sortie de la porte OU reproduit l'e.b présent sur sa seconde entrée, soit 0 ou 1.

Les sorties des 26 portes OU formant ce circuit logique 8 sont reliées à 26 entrées d'une seconde mémoire 9 formée de 26 lignes dans laquelle sont enregistrés les blocs de 180 e.b ainsi traités. En effet, ce n'est qu'à la fin de la correction d'un bloc de données qu'il est possible de savoir si le bloc est réellement corrigé ou si la configuration des erreurs dans ce bloc était telle que la capacité de correction du code correcteur d'erreurs a été insuffisante pour que ces erreurs soient corrigées.

Un circuit logique de contrôle 10 reçoit les suites d'e.b délivrées par l'ensemble 5 des détecteurs correcteurs d'erreurs, $D_o$ à $D_{25}$. Ce circuit logique est commandé par un signal de commande délivré par le circuit, 6, de gestion des décodeurs. Lorsque le nombre d'erreurs détectées est supérieur à la capacité de correction du dispositif, le circuit logique 10 fournit un signal CI, indiquant que la configuration des erreurs détectées est telle qu'elle excède la capacité de correction du dispositif.

Lorsque la configuration des erreurs détectées peut être corrigée, c'est-à-dire qu'une erreur longue est détectée sur une seule des pistes paires ou impaires (ou éventuellement une erreur longue sur une seule piste paire et également une erreur longue sur une seule piste impaire, (qui peuvent être deux pistes adjacentes) la correction consiste à un premier temps à remplacer la piste présentant des erreurs par la piste de parité associée, $P_o$ ou $P_{25}$ selon que la piste à remplacer est une piste paire ou impaire, puis à calculer les données de départ en effectuant un calcul de parité du groupe de pistes concerné (pistes paires ou pistes impaires). Une dernière étape de la correction consiste alors à remplacer les données fausses de la piste à corriger par les e.b obtenus par le calcul de parité. La partie du circuit de détection et de correction correspondant à cette correction comporte à cet effet deux multiplexeurs 14 et 15 reliés aux sorties de la mémoire 9, cette mémoire 9 ayant 26 sorties correspondant à ses 26 lignes qui correspondent elles-mêmes aux 26 pistes lues de l'enregistreur. Le multiplexeur 14 a treize entrées de signal reliées aux sorties de la mémoire 9 correspondant aux lignes impaires et une entrée de commande reliée à la sortie $S_1$ du circuit logique de contrôle 10 indiquant le numéro de la piste impaire à corriger.

De même, le multiplexeur 15 a treize entrées de signal reliées aux sorties de la mémoire 9 correspondant aux lignes paires et une entrée de commande reliée à la sortie $S_2$ du circuit logique de contrôle 10 indiquant le numéro de la piste paire à corriger. Les multiplexeurs 14 et 15 sont tels que les données présentes sur leurs entrées, respectivement de rangs 25 et 0, remplacent les données sur l'entrée de rang 2n+1 ou de rang 2n, 2n+1 et 2n étant les numéros des pistes à corriger donnés par les entrées de commande. Les multiplexeurs 14 et 15 ont 12 sorties respectivement reliées aux 12 entrées de deux calculateurs de parité 16 et 17 et également aux 12 premières entrées de deux autres multiplexeurs, respectivement 18 et 19. Les sorties des calculateurs de parité 16 et 17 sont reliées à une 13$^e$ entrée des multiplexeurs, respectivement 18 et 19.

Ces multiplexeurs fonctionnent de la même manière que les précédents, leurs entrées de commande étant également reliées aux sorties $S_1$ et $S_2$ du circuit logique de contrôle pour sélectionner, parmi les 12 premières entrées du multiplexeur, celle qui doit être remplacée par la 13$^e$ entrée.

Les sorties de ces multiplexeurs 18 et 19 délivrent alors les suites d'éléments binaires corrigées.

La dernière étape pour parvenir à la reconstruction de la suite d'octets ayant donné lieu à l'enregistrement consiste alors à regrouper convenablement les sorties de ces multiplexeurs pour reconstituer les trois octets enregistrés simultanément et les restituer séquentiellement dans leur ordre d'arrivée.

Pour cela, trois registres à 8 entrées, respectivement 31, 32 et 33 sont reliés aux sorties des multiplexeurs et regroupent les e.b pour reconstituer les octets d'entrée. Un multiplexeur 20 à 24 entrées, transmet successivement les 8 e.b présents sur les sorties des registres 31, 32 et 33 à ses 8 sorties.

A cette fin, le signal d'horloge $H_L$ de lecture reçu de l'enregistreur est appliqué à un circuit multiplicateur de rythme 34 qui multiplie par 3 le rythme du signal d'horloge qu'il reçoit. Les 8 sorties du multiplexeur 20 sont reliées aux 8 entrées d'un registre de sortie 35 qui délivre la suite des octets à un rythme égal à 3 fois le rythme de l'horloge de lecture de l'enregistreur.

Bien sûr, l'horloge de lecture $H_L$ commande le circuit de contrôle 10 mais également la mise en mémoire dans les mémoires 7 et 9 et également la sortie des informations des mémoires (ces mémoires étant en fait constituées de 26 registres à décalage) ; $H_L$ commande aussi le transfert des données des registres 31, 32 et 33 au multiplexeur 20.

La figure 4, qui décrit un circuit décodeur $D_i$, permet d'illustrer plus précisément le fonctionnement du décodeur correcteur selon l'invention.

Comme il a été indiqué ci-dessus, les circuits codeurs $C_i$ utilisent un code de Fire raccourci, c'est-à-dire qu'au lieu de coder des blocs de 1643 e.b, ils codent des blocs courts de 180 e.b. A la réception pour réaliser un décodage correct, il faut tenir compte de ce raccourcissement des blocs. Pour cela, avant d'effectuer la division des blocs de données binaires restitués par le polynôme générateur g(x), ces données sont multipliées par le reste de la division en base 2 de $x^{1471}$ par le polynôme générateur g(x), ce reste étant le polynôme $h(x) = x^{18} + x^{15} + x^5$, ($x^{1471} = x^{(1643-192)+20}$ 1643 e.b étant la longueur des blocs dans le code de Fire non raccourci, 192 étant la longueur majorée à l'octet supérieur des blocs dans le code choisi et 20 étant le nombre d'e.b de redondance). En pratique la multiplication par h(x) et la division par g(x) peuvent être simultanées.

Le décodeur $D_i$ comporte donc un circuit 50 de multiplication par h(x) et de division par g(x). Un exemple de réalisation de ce circuit est représenté sur la figure 4. Il comporte, comme le codeur correspondant, 20 bascules en série, la sortie de l'une étant reliée à l'entrée de la suivante soit directement, soit par l'intermédiaire d'une porte OU exclusif pour une première série de bascules de rangs 3, 7, 13, 16, et pour une seconde série de bascules de rangs 5, 15 et 18.

Les secondes entrées des portes correspondant à la première série (polynôme g(x)) sont reliées à la sortie de la bascule de rang 20. Les secondes entrées des portes correspondant à la seconde série, (polynôme h(x)) sont reliées à l'entrée $e_c$ de signal codé. Ce circuit permet donc de multiplier le polynôme formé par la suite des données restituées par l'enregistreur par $h(x) = x^5 + x^{15} + x^{18}$ et de diviser simultanément par $g(x) = x^{20} + x^{16} + x^{13} + x^7 + x^3 + 1$. Ce traitement est effectué sur chaque bloc de 200 e.b restitués ; le résultat, formé de 20 e.b est obtenu sur les sorties des 20 bascules à la fin de chaque bloc.

Lorsque les e.b de données n'ont pas été affectés par des erreurs, ce résultat est nul, c'est-à-dire que 20 "0" sont présents sur les sorties des bascules. Dans ce cas, les 180 e.b du bloc recopiés dans la mémoire 7 (figure 3) sortent un à un de cette mémoire et sont recopiés sans être corrigés dans la mémoire 9 (figure 3).

Par contre, si·le résultat est différent de 0, une ou plusieurs erreurs ont été introduites.

Il est alors nécessaire de détecter, l'emplacement des erreurs dans la suite des données afin de les corriger, tout en commençant le traitement du bloc suivant. Pour cela, les 20 e.b formant le résultat du traitement sont transférés dans un second circuit, 51, de division par le polynôme g(x). Ce second circuit de division reçoit des e.b en parallèle et non des e.b en série ; mais comme le premier, il comporte un circuit de rebouclage, de la vingtième sortie sur l'entrée, représenté à l'extérieur du diviseur sur la figure car un circuit interrupteur 53 est prévu dans cette boucle. En cours de division, lorsque les 13 premiers e.b du résultat sont "0", alors les 7 e.b qui suivent indiquent l'emplacement de l'erreur dans la suite des données. Cette combinaison est détectée par un circuit, 52, à portes ET ; lorsqu'elle est détectée, un signal de commande d'ouverture est envoyé au circuit à portes 53 qui ouvre le rebouclage de la chaine de division du circuit 51.

Ce circuit à portes 53 commande également lorsqu'il y a lieu, la correction, le signal "1" correspondant (indiquant la présence d'une erreur) étant fourni au circuit à portes OU, 8, de la figure 3 pour inverser l'e.b erroné fourni simultanément par la mémoire 7 (figure 3).

Si au cours de la division (et le résultat du premier traitement par le circuit étant différent de 0), ces 13 premières sorties du circuit 51 ne sont jamais simultanément à 0, les erreurs détectées excèdent la capacité de correction du code. Cette configuration est détectée au moyen d'une porte ET, 54 dont les deux entrées sont respectivement reliées à la sortie du circuit logique à portes OU, 52 et à la sortie d'un second circuit logique à portes OU, 55 dont les entrées sont reliées aux sorties 14 à 20 du circuit de division 51. La sortie de cette porte est reliée à l'entrée d'un circuit de détection 56 dont la sortie fournit un signal $C_I$ adapté à l'ordinateur de gestion du système indiquant que la configuration d'erreurs détectées ne peut être corrigée par le code correcteur mis en œuvre. La porte 54 et ce circuit de détection 56 sont inclus sur le schéma de la figure 2 dans le circuit logique de contrôle 10.

Ainsi, comme indiqué ci-dessus lorsqu'une seule piste (ou deux pistes de parités différentes) ne peut pas être corrigée, un signal $S_1$ ou $S_2$ indique la parité de cette piste (éventuellement les deux), et la correction est alors effectuée à partir de la piste (ou des pistes) de parité correspondante.

En pratique il est à remarquer que, le code détecteur permettant de corriger des paquets courts de 7 erreurs sur chacune des pistes, il n'est que rarement observé plus de deux configurations d'erreurs non correctibles par ce code qui nécessitent de faire appel aux pistes de parité. Il est donc rare que le système soit en défaut.

L'invention n'est évidemment pas limitée au mode de réalisation précisément décrit et réalisé, donné à titre d'exemple.

En particulier, pour fixer les idées, un certain nombre de chiffres ont été indiqués tant en ce qui concerne le nombre des pistes enregistrées et lues simultanément qu'en ce qui concerne le nombre d'e.b en série dans les blocs de données. En pratique ces indications peuvent être modifiées pour tenir compte de l'enregistreur utilisé.

Néanmoins en ce qui concerne le code correcteur proprement dit, le code de Fire raccourci en (200, 180) est pratique du fait de la simplicité des nombres d'éléments utilisés.

REVENDICATIONS

1. Dispositif de correction, en temps réel, d'erreurs sur des données enregistrées sur un support magnétique multipiste, comportant un dispositif de traitement de données numériques avant leur enregistrement en parallèle sur un enregistreur-lecteur multipistes et un dispositif de traitement des données numériques restituées après leur lecture en parallèle sur l'enregistreur-lecteur, caractérisé en ce que ce dispositif de correction met en œuvre deux modes de correction associés ne consommant qu'une redondance totale faible, un mode de correction d'erreurs courtes à partir d'éléments binaires de redondance introduits par le dispositif de traitement de données avant leur enregistrement par un codage détecteur correcteur d'erreurs du type code de Fire raccourci, introduisant pour un bloc de N éléments binaires en série à enregistrer sur une piste de l'enregistreur n éléments binaires de redondance, et un mode de correction d'erreurs longues mettant en œuvre des éléments binaires de parité, à enregistrer sur au moins une piste à réserver à cet effet, résultant du codage des éléments binaires parallèles à enregistrer simultanément.

2. Dispositif selon la revendication 1, caractérisé en ce que les dispositifs de traitement des données avant leur enregistrement et après leur lecture mettent en œuvre, pour le mode de correction des erreurs longues, deux suites d'éléments binaires de parité, à enregistrer sur deux pistes réservées à cet effet, l'une correspondant à un premier groupe d'éléments binaires en parallèle et l'autre aux éléments binaires parallèles restants formant un second groupe.

3. Dispositif selon la revendication 2, caractérisé en ce que le premier groupe d'éléments binaires correspond aux données à enregistrer sur les pistes paires et l'autre groupe aux données à enregistrer sur les pistes impaires, le dispositif permettant alors de corriger des erreurs longues sur deux pistes consécutives.

4. Dispositif selon l'une quelconque des revendications précédentes, caractérisé en ce que les dispositifs de traitement des données mettent en œuvre, pour la correction des erreurs courtes, un code de Fire raccourci en (200, 180) N étant égal à 180 et n à 20.

5. Dispositif selon la revendication 4, caractérisé en ce que le dispositif de traitement des données avant leur enregistrement comporte un dispositif de multiplexage (11, 12, 13) des données à enregistrer pour former autant de suites d'éléments binaires série en parallèle que de pistes disponibles sur l'enregistreur pour l'enregistrement de ces données, soit k le nombre de ces pistes, un dispositif de calcul des éléments binaires de parité (2), et un dispositif de codage (3) pour le calcul des éléments binaires de redondance pour chaque bloc d'une suite d'éléments binaires en série, ce dispositif de codage comportant un ensemble (3) de k codeurs élémentaires.

6. Dispositif selon la revendication 5, caractérisé en ce que, pour un codage suivant un code de Fire, chaque codeur élémentaire comporte un circuit de division (30) par le polynôme générateur du code de Fire $g(x) = x^{20} + x^{16} + x^{13} + x^7 + x^3 + 1$ recevant sur son entrée une suite d'éléments binaires et fournissant sur sa sortie les 20 éléments binaires de redondance transmis à la suite de chaque bloc de données série.

7. Dispositif selon l'une quelconque des revendications 5 et 6, caractérisé en ce que le dispositif de traitement des données restituées, après leur lecture en parallèle sur l'enregistreur lecteur, comporte un circuit de décodage (5) comportant k décodeurs élémentaires et un circuit à mémoire (7), ces deux circuits recevant les données restituées, un circuit de correction (8) recevant les données présentes sur les sorties du circuit de décodage (5) et celles présentes sur les sorties du circuit à mémoire (7) pour corriger les erreurs courtes, un circuit logique (10) de détection des erreurs longues, un circuit de correction des erreurs longues comportant des calculateurs de parité (16 et 17) et des multiplexeurs (14, 15, 18 et 19), les sorties de ce circuit de correction étant reliées aux entrées d'un circuit de multiplexage comportant des registres (31, 32 et 33) et un multiplexeur (20) pour fournir à un registre de sorties les données corrigées.

FIG_1

1/4

0042776

CODEUR

CIRCUIT DE DIVISION

FIG_2

2/4

0042776

FIG_3

0042776

FIG_4

$e_c$

50

51

$xh(x)$
$\div g(x)$

1 2 3  4 5  6 7  8 9 10 11 12 13  14 15  16  17 18  19 20

CIRCUIT DE DIVISION : $g(x) = x^{20} + x^6 + x^{13} + x^7 + x^3 + 1$

CIRCUIT LOGIQUE

CIRCUIT LOGIQUE

52

55

53

CIRCUIT INTER-RUPTEUR

10

54

56

CI

0042776

Office européen
des brevets

**RAPPORT DE RECHERCHE EUROPEENNE**

EP 81 40 0905

| DOCUMENTS CONSIDERES COMME PERTINENTS | | | CLASSEMENT DE LA DEMANDE (Int. Cl.³) |
|---|---|---|---|
| Catégorie | Citation du document avec indication, en cas de besoin, des parties pertinentes | Revendication concernée | |
| | IEEE TRANSACTIONS ON COMPUTERS, vol. C-17, no. 10, octobre 1968 NEW YORK (US) M.Y. HSIAO: "Single-channel error correction in an f-channel system", pages 935-943.<br><br>* figures 1-14, article en entier *<br><br>-- | 1-3, 5-7 | G 11 B  5/09 G 06 F  11/10// H 04 L   1/10 |
| | US - A - 4 052 698 (RAGLE)<br><br>* figure 1; colonne 3, ligne 50 à colonne 11, ligne 15 *<br><br>-- | 1-3, 5-7 | **DOMAINES TECHNIQUES RECHERCHES (Int. Cl.³)** |
| | THE BELL SYSTEM TECHNICAL JOURNAL, vol. 55, no. 2, février 1976 NEW YORK (US) SLOANE: "A simple description of an error correcting code for high-density magnetic tape", pages 157-165.<br><br>* figures 1-6; page 157, dernier alinéa à page 164, ligne 22 *<br><br>-- | 1-3,5-7 | G 11 B  5/09 G 06 F  11/10 H 04 L   1/10 |
| | IBM TECHNICAL DISCLOSURE BULLETIN, vol. 20, no. 5, octobre 1977 NEW YORK (US) CHEN: "Double-track error correction with a cyclic redundancy check code for magnetic tapes", pages 1847-1852.<br><br>* en entier *<br><br>--<br>./.. | 1-3,5-7 | **CATEGORIE DES DOCUMENTS CITES**<br><br>X: particulièrement pertinent<br>A: arrière-plan technologique<br>O: divulgation non-écrite<br>P: document intercalaire<br>T: théorie ou principe à la base de l'invention<br>E: demande faisant interférence<br>D: document cité dans la demande<br>L: document cité pour d'autres raisons<br><br>&: membre de la même famille, document correspondant |

Le présent rapport de recherche a été établi pour toutes les revendications

| Lieu de la recherche | Date d'achèvement de la recherche | Examinateur |
|---|---|---|
| La Haye | 31.08.1981 | CARTRYSSE |

**Office européen des brevets**

**RAPPORT DE RECHERCHE EUROPEENNE**

| DOCUMENTS CONSIDERES COMME PERTINENTS | | | CLASSEMENT DE LA DEMANDE (Int. Cl. ³) |
|---|---|---|---|
| Catégorie | Citation du document avec indication, en cas de besoin, des parties pertinentes | Revendica-tion concernée | |
| | IEEE TRANSACTION ON INFORMATION THEORY, vol. IT-15, no. 1, janvier 1969 NEW YORK (US). CHIEN: "Burst-correcting codes with high-speed decoding", pages 109-113. <br><br> * figures 1-3; page 109, colonne de gauche à page 112, colonne de droite, dernière ligne * | 1,5,6 | |
| | CONFERENCE RECORD, 1978, NA-TIONAL TELECOMMUNICATIONS CON-FERENCE - BIRMINGHAM, vol. 2, 3-6 décembre 1978 BIRMINGHAM, ALABAMA INOUE et al.: "A new class of burst-error-correcting codes and it's application to PCM tape recording systems", pages 20.6.1 - 20.6.5 <br><br> * en entier * | 1-3, 5-7 | DOMAINES TECHNIQUES RECHERCHES (Int. Cl. ³) |
| A | IBM TECHNICAL DISCLOSURE BULLETIN, vol. 17, no. 2, juillet 1974 NEW YORK (US) PATEL: "Coding scheme for multiple sections error correc-tion", pages 473-475. | 1 | |
| | ./.. | | |

OEB Form 1503.2   06.78

# 0042776

**Office européen**
**des brevets**

## RAPPORT DE RECHERCHE EUROPEENNE

Numéro de la demande

EP 81 40 0905

-3-

| DOCUMENTS CONSIDERES COMME PERTINENTS | | | CLASSEMENT DE LA DEMANDE (Int. Cl. 3) |
|---|---|---|---|
| Catégorie | Citation du document avec indication, en cas de besoin, des parties pertinentes | Revendica-tion concernée | |
| A | IBM JOURNAL OF RESEARCH AND DEVELOPMENT, vol. 18, no. 26, novembre 1974 NEW YORK (US) PATEL et HONG: "Optimal rectangular code for high density magnetic tapes", pages 579-588. | 1 | |
| A | US - A - 3 439 331 (BROWN et al.) | 1 | DOMAINES TECHNIQUES RECHERCHES (Int. Cl. 3) |

OEB Form 1503.2   06.78